# EUROPÄISCHE PATENTSCHRIFT

(11) **EP 0 897 654 B1**
(45) Veröffentlichungstag und Bekanntmachung des Hinweises auf die Patenterteilung: **22.12.1999**
(21) Anmeldenummer: 97922889.7
(22) Anmeldetag: 29.04.1997
(51) Int. Cl.: H05K 3/32, H05K 3/36

(54) **VERFAHREN ZUR HERSTELLUNG ELEKTRISCH LEITENDER VERBINDUNGEN ZWISCHEN ZWEI ODER MEHR LEITERSTRUKTUREN**
PROCESS FOR ESTABLISHING ELECTRICALLY CONDUCTING CONNECTIONS BETWEEN TWO OR MORE CONDUCTOR STRUCTURES
PROCEDE DE REALISATION DE CONNEXIONS ELECTROCONDUCTRICES ENTRE AU MOINS DEUX STRUCTURES DE CONDUCTEURS

(30) Priorität: 06.05.1996 DE 19618099
(43) Veröffentlichungstag der Anmeldung: 24.02.1999
(73) Patentinhaber: SIEMENS AKTIENGESELLSCHAFT, 80333 München (DE)
(72) Erfinder: MUNDIGL, Josef, D-93182 Duggendorf (DE)
(86) Internationale Anmeldenummer: DE9700871
(87) Internationale Veröffentlichungsnummer: WO9742798

(56) Entgegenhaltungen:
- EP-A- 0 450 470
- EP-A- 0 567 814
- DE-A- 1 951 778
- DE-A- 4 327 560
- DE-A- 4 337 920

## Beschreibung

Die Erfindung betrifft ein Verfahren zur Herstellung partieller elektrisch leitender Kontaktverbindungen zwischen zwei Leiterstrukturen und insbesondere zwischen zwei Leiterstrukturen, von denen wenigstens eine auf einen stabilisierenden Träger aufgebracht ist.

Unter Leiterstruktur soll jede Art von leitender Struktur verstanden werden, also grundsätzlich jedes elektrisch leitende Bauteil, wie beispielsweise die elektrischen Kontakte von SMD- und IC-Bausteinen oder ähnliches. Insbesondere umfaßt der Begriff aus Metallschichten oder -folien herausgearbeitete leitende Strukturen und vor allem aus leitfähigen Folien herausgearbeitete Schaltkreise. Die leitfähigen Folien können beispielsweise eine Dicke von 12 - 200 µm oder auch mehr aufweisen.

Die leitenden Strukturen können zur mechanischen Verstärkung und Isolierung auf einen Träger aufgedampft, aufgeklebt oder auf andere bekannte Weise aufgebracht oder in den Träger integriert sein. Derartige Systeme werden nachfolgend als Leiterverbundsysteme bezeichnet. Als Träger eignen sich unter anderem Kunststoffe und insbesondere thermoplastische Kunststoffe wie Polyimide, Polyester, Polyolefine, halogenierte Polyolefine, gegebenenfalls verstärkte Polyepoxide und Misch- oder Pfropfpolymerisate dieser Polymere. Zur Verbesserung des Korrosionsschutzes können die Leiterstrukturen zudem oberflächenbehandelt oder -veredelt sein.

Speziell bei derartigen Mehrlagenstrukturen mit zwei oder mehr Leiterstrukturen, von denen sich wenigstens eine auf einem thermoplastischen Träger befindet, ergeben sich jedoch Probleme bei der Herstellung der leitenden Verbindungen zwischen den Leiterstrukturen. Thermische Verfahren bereiten dadurch Schwierigkeiten, daß unter Einwirkung von Wärme der thermoplastische Träger zumindest in dem Bereich der unmittelbaren Wärmeeinwirkung schmilzt. Globale Wärmeeinbringung (im Ofen etc.) ist somit nicht anwendbar. Verfahren mit lokaler Wärmeeinkopplung und kurzzeitiger Steuerung sind zu bevorzugen (z.B. IR-, Laser-, Heißluftverfahren mit dünner Düse, Thermokompressionsverfahren, Widerstandsverfahren, Gap-Lötbügel-Verfahren usw.). Besonders gravierend sind die Schwierigkeiten, soll eine auf einem thermoplastischen Träger aufgebrachte Leiterstruktur mit einem größeren und/oder dikkeren Leiterverbundsystem leitend verbunden werden. Dies können beispielsweise Leiterstruktur-Verbundsysteme mit Trägerfolien für SMD-Bausteine oder für metallische Anschlußrahmen (Leadframes) mit wenigstens einem integrierten IC-Baustein sein. Die Trägerfolien sind hier üblicherweise relativ dick und flächig. Wird die thermische Energie zur Herstellung der leitenden Verbindung von der Seite des thermoplastischen Trägers zugeführt, muß sie durch den Träger hindurch geleitet werden und führt zu dessen Aufschmelzen. Wird die thermische Energie von der anderen Seite zugeführt, also beispielsweise über einen Anschlußrahmenträger, wird ein beträchtlicher Teil der zugeführten Energie über den Anschlußrahmen, der in der Regel aus stark wärmeleitfähigem Metall besteht, abgeführt. Einerseits steigert das den Energiebedarf, der für die Ausbildung der leitenden Verbindung erforderlich ist, andererseits führt die Wärmeableitung zur Aufheizung des Trägers im Bereich um die Verbindungsstelle. Insbesondere bei Verwendung eines thermoplastischen Trägers schmilzt dieser in den meisten Fällen so stark auf, daß die Mehrschichtstruktur aufgrund der Deformation oder Zerstörung nicht mehr brauchbar ist.

Thermische Verfahren sind zur Herstellung der leitenden Verbindungen daher nur sehr begrenzt oder gar nicht einsetzbar. Wurden bisher thermische Verfahren, wie Schweiß-, Löt-, Ultraschall-, Thermokompressions-, Thermosonic- oder Laserverfahren, zur Verbindung von Leiterstrukturen zu Mehrlagenstrukturen, die wenigstens einen thermoplastischen Träger umfassen, überhaupt eingesetzt, dann nur unter verschiedenen Einschränkungen. Entweder erfolgte eine aufwendige Umstrukturierung und neue Dimensionierung der Kontaktstellen oder die thermoplastischen Träger wurden durch andere und teuerere Materialien ersetzt. Eine andere Möglichkeit bestand darin, die Temperatureinkopplung gering zu halten, um Schädigungen des thermoplastischen Materials zu verhindern. Dies führte jedoch zu einer Verringerung der Festigkeit der erzielten Verbindung.

In der EP-A-0 450 470 ist ein gattungsgemäßes Verfahren zur Herstellung elektrisch leitender Verbindungen zwischen zwei Leiterstrukturen, die jeweils mit einem Träger aus thermoplastischem Kunststoff verbunden sind, beschrieben. Die Leiterverbundsysteme weisen im Bereich der Kontaktstellen der Leiterstruktur Öffnungen auf. Zur Herstellung der elektrisch leitenden Verbindung werden die Leiterverbundsysteme beispielsweise in einer Heizpresse erwärmt. Dieses Verfahren ist mit den bekannten Nachteilen verbunden.

**Aufgabe** der Erfindung war es, ein Verfahren anzugeben, mit dem zwei oder mehr Leiterstrukturen insbesondere mit Hilfe eines thermischen oder thermisch unterstützten Verfahrens auf einfache und kostengünstige Weise und möglichst stabil miteinander elektrisch leitend verbunden werden können. Dieses Verfahren sollte Beschädigungen eines eine oder beide Leiterstrukturen unterstützenden Trägers weitgehend verhindern. Zudem sollte das Verfahren einen möglichst geringen Energieaufwand erfordern.

Die Lösung der gestellten Aufgaben gelingt mit dem Verfahren gemäß Anspruch 1. Weitere Ausführungsformen ergeben sich aus den Unteransprüchen.

Die Erfindung betrifft also ein Verfahren zur Herstellung wenigstens einer elektrisch leitenden Verbindung zwischen zwei oder mehr Leiterstrukturen, von denen wenigstens eine mit einem Träger zu einem Leiterverbundsystem verbunden ist. Wenigstens ein Träger besteht dabei aus thermoplastischem Kunststoff. In wenigstens einem der Leiterverbundsysteme sind im Bereich der Kontaktstellen der Leiterstruktur Durchbrüche vorgesehen. Das Verfahren ist dadurch gekennzeichnet, daß durch die Durchbrüche der eigentlichen Verbindungsstelle direkt und gezielt thermische Energie zugeführt wird. Die Durchbrüche erlauben den unmittelbaren Zugang zur eigentlichen Verbindungsstelle und ermöglichen es, die Verbindung dort gezielt auszuführen.

Die Verbindung durch Zufuhr thermischer Energie kann beispielsweise durch Wärmestrahlung, Schweißen, Löten, Thermokompression, mit Hilfe von Ultraschall, durch Laser- oder Thermosonicverfahren erfolgen. Bevorzugte Schweißverfahren sind das Punkt-, Gap- oder Spaltschweißen. In einer bevorzugten Ausführungsform kann eine elektrisch leitende Masse in die Durchbrüche eingebracht werden. Die elektrisch leitende Masse kann z.B. eine Leitpaste, ein Leitkleber, eine Lotpaste oder Lotfolie sein. Vorzugsweise wird der Verbindungsstelle zusätzlich thermische Energie zugeführt, wobei grundsätzlich eines der oben genannten Verfahren Anwendung finden kann. Das Verfahren ist entsprechend der Wahl des Folienträgers, des Additives und der zu verbindenden Partner zu wählen und sollte in Abhängigkeit der beteiligten Stoffe auf eine Mindesteinwirkdauer reduziert werden. Nachgeschaltete oder prozeßbegleitende Kühlung des thermoplastischen Substratträgers ist empfehlenswert.

Aufgrund des durch die Durchbrüche im Leiterverbundsystem ermöglichten direkten Zugangs zu den Verbindungsstellen ist die Herstellung der Verbindung zwischen zwei Leitersystemen auf sehr einfache Art und Weise möglich. Die Probleme des Standes der Technik bei Verwendung thermischer oder thermisch unterstützter Verfahren werden durch die vorliegende Erfindung weitgehend vermieden. So muß beispielsweise die thermische Energie nicht mehr durch einen Träger hindurchgeleitet werden, sondern setzt werden, die ebenfalls vom Standpunkt der Abfallentsorgung oder des Recyclings vorteilhaft sind.

Von besonderem Vorteil ist die Erfindung, wenn leitende Verbindungen zu relativ dicken Leiterverbundsystemen hergestellt werden sollen, wie z.B. zu Leadframe-Folien. Da erfindungsgemäß die thermische Energie der Verbundstelle gezielt zugeführt werden kann, kann die Aufheizung des metallischen Anschlußrahmens weitgehend vermieden werden, und die Ableitung von Wärme in den Träger und dessen Aufschmelzen werden praktisch nicht beobachtet.

Die Erfindung soll nun unter Bezugnahme auf die Zeichnungen näher erläutert werden. Dabei zeigen
- Fig. 1: schematisch den Aufbau eines Mehrlagensystems, auf das das erfindungsgemäße Verfahren angewendet werden kann, im Querschnitt;
- Fig. 2: schematisch das Mehrlagensystem gemäß Fig. 1 mit ausgebildeten Verbindungen;
- Fig. 3: schematisch das Mehrlagensystem gemäß Fig. 1 mit einer anderen möglichen Art der Verbindungs-ausbildung;
- Fig. 4: schematisch verschiedene Mehrlagensysteme im Querschnitt, links in Form der Einzelkomponenten, rechts im Verbund mit schematischer Veranschaulichung der möglichen Verbindungstechnik;
- Fig. 5: schematisch beispielhafte Formen der erfindungsgemäßen Durchbrüche im Leiterverbundsystem in Draufsicht.

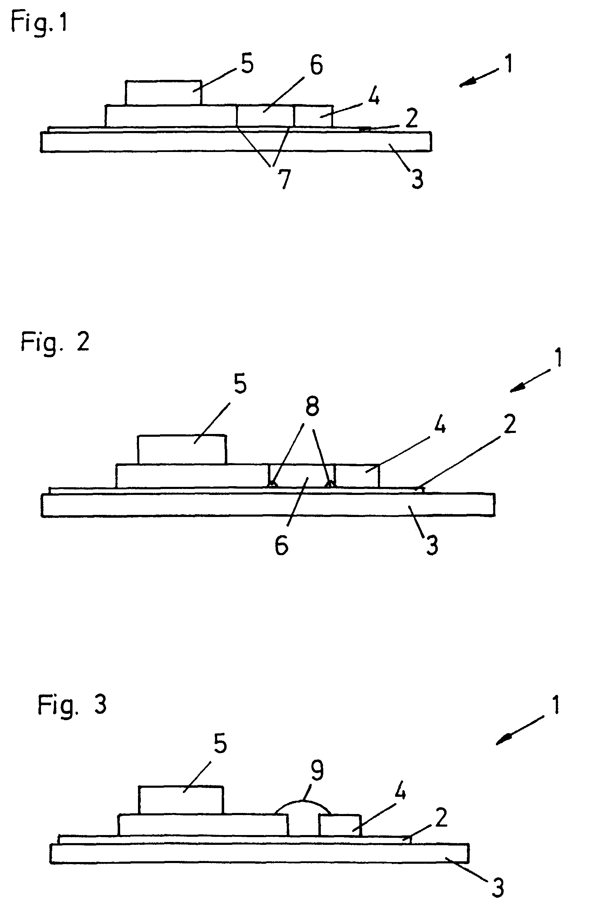

Im einzelnen zeigt Fig. 1 schematisch ein mögliches Mehrlagensystem, auf das das erfindungsgemäße Verfahren angewendet werden kann. Das Mehrlagensystem 1 setzt sich im gezeigten Fall aus zwei Leiterverbundsystemen zusammen, nämlich einerseits einer Leiterstruktur 2, die auf einem Träger 3 angeordnet ist und andererseits eine sogenannte Leadframe-Folie 4, in die ein metallischer Anschlußrahmen (nicht gezeigt) integriert ist. Auf der Leadframe-Folie 4 ist ein IC- oder SMD-Baustein 5 angeordnet.

Diese Anordnung ist nur beispielhaft. Prinzipiell eignet sich die Erfindung für die Verbindung aller Leiterstrukturen, von denen wenigstens eine mit einem Träger zu einem Leiterverbundsystem kombiniert ist.

Erfindungsgemäß wird wenigstens eines der in dem Mehrlagensystem vorhandenen Leiterverbundsysteme mit Durchbrüchen versehen. Die Durchbrüche befinden sich im Bereich der Kontaktstellen der Leiterstruktur im Leiterverbundsystem. In Fig. 1 ist ein Durchbruch gezeigt, der mit 6 bezeichnet ist. Der Durchbruch erlaubt den direkten Zugang zu der Verbindungsstelle. Bei Zufuhr thermischer Energie zur Herstellung der Verbindung erfolgt die Verbindungsbildung zuerst im Bereich der mit 7 gekennzeichneten Stellen.

Die Größe der Durchbrüche beträgt zweckmäßig 0,3 bis 1,5 mm im Durchmesser bei einer Substratdicke von 50 µm bis 1000 µm und mehr. Die Durchbrüche sind abhängig vom Verfahren, den verwendeten Materialien und deren Dimensionen sowie der Wahl der Verbindungstechnik (Löten, Schweißen, Kleben, usw.).

Fig. 2 zeigt die Mehrlagenstruktur gemäß Fig. 1 mit thermisch ausgebildeten Verbindungen. Mit 8 sind die durch Zufuhr thermischer Energie entstandenen Schmelzstellen bezeichnet.

Fig. 3 zeigt das Mehrlagensystem gemäß Fig. 1, bei dem die Verbindungen mit Hilfe einer elektrisch leitenden Masse, z.B. einem Lot oder einer Leitpaste, hergestellt wurden. Die in den Durchbruch eingefügte leitende Masse ist mit 9 bezeichnet.

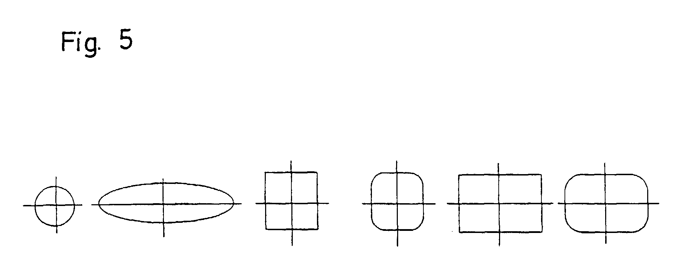

Die Durchbrüche 6 können auf verschiedenste Weise hergestellt werden. Beispielsweise können sie eingestanzt, eingeprägt, eingeschnitten oder -gesägt, eingefräst, eingeschmolzen, geätzt, gedruckt oder auf sonstige Weise erzeugt werden. Form und Größe der Durchbrüche richtet sich nach dem jeweiligen Aufbau des Leiterverbundsystems und dessen geplanter Verwendung. Wegen der einfachen Herstellung sind Durchbrüche mit kreisförmigem Querschnitt bevorzugt. Grundsätzlich können die Durchbrüche jedoch jede beliebige Querschnittsform aufweisen, also beispielsweise quadratisch, rechteckig, vieleckig, oval usw. sein. Längliche Formen können für flächige Verbindungsausbildungen von Vorteil sein. Die Ecken der Durchbrüche können abgerundet sein. Beispielhafte Querschnittsformen der Durchbrüche sind in Fig. 5 gezeigt.

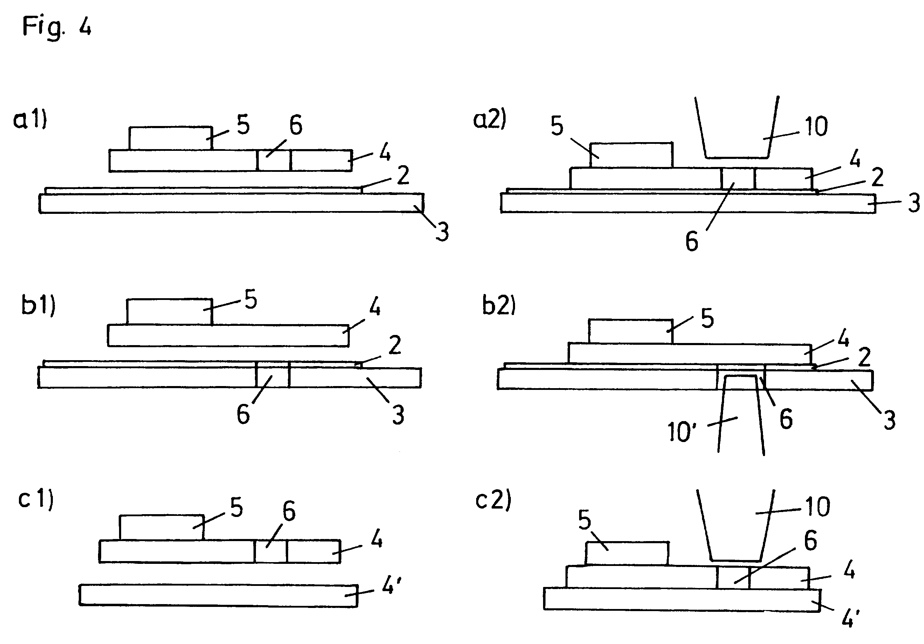

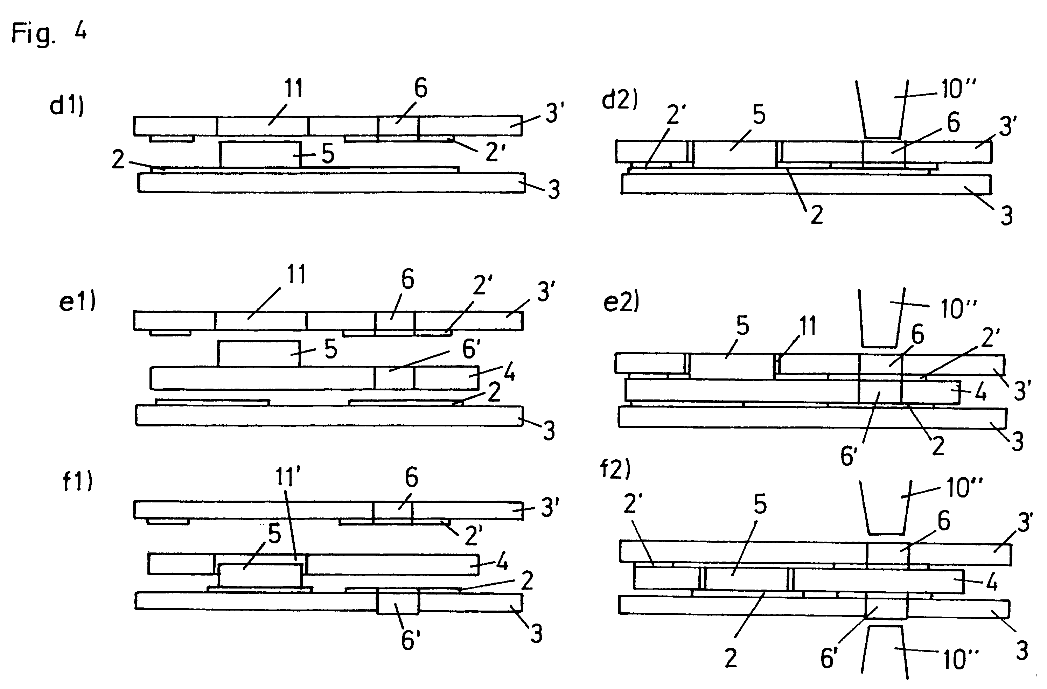

Fig. 4 zeigt schematisch einige weitere Mehrlagenstrukturen, die mit dem erfindungsgemäßen Verfahren verbunden werden können. Auf der linken Seite sind jeweils die nicht verbundenen Einzelkomponenten zu sehen, während die rechte Seite die entsprechenden Mehrlagenstrukturen zeigt und die Herstellung der Verbindungen schematisch veranschaulicht.

Das in Fig. 4a dargestellte System entspricht dem der Fig. 1 bis 3. In Fig. 4a2) bezeichnet 10 ein Mittel zum Zuführen thermischer Energie. Beispielsweise kann es sich um eine Ultraschall- und/oder Thermokompressions-Elektrode handeln oder um jedes andere Mittel, mit dem thermische Energie auf die bereits beschriebene Art zugeführt werden kann.

Der Vorteil gegenüber den Verfahren des Standes der Technik besteht darin, daß die Energie gezielt und örtlich begrenzt der gewünschten Verbindungsstelle zugeführt werden kann. Weder muß die thermische Energie zunächst einen Träger durchdringen noch besteht die Gefahr, daß größere Energiemengen durch den Anschlußrahmen in der Leadframe-Folie 4 abgeleitet werden und die Folie zu schmelzen beginnt. Erfindungsgemäß können deshalb auch temperaturempfindliche Trägermaterialien wie Thermoplaste verwendet werden, ohne daß diese bei der Herstellung der leitenden Verbindung beschädigt würden.

Fig. 4b zeigt eine alternative Möglichkeit, eine Leadframe-Folie 4 mit einem Leiterverbundsystem aus Trägerfolie 3 und Leiterstruktur 2 zu verbinden. Anstelle des Durchbruchs in der Leadframe-Folie ist der Durchbruch im unteren der beiden Leiterverbundsysteme, also in der Trägerfolie 3 und der Leiterstruktur 2 ausgebildet. In einem Mehrlagensystem mit zwei oder mehr Leiterverbundsystemen wird bevorzugt das dickste der Leiterverbundsysteme durchbrochen. 10' bezeichnet ein Mittel zum Zuführen thermischer Energie, beispielsweise ein Mittel zum Zuführen von Laser- oder IR-Strahlung.

Fig. 4c stellt ein Mehrlagensystem dar, bei dem zwei Leadframe-Folien 4 und 4' miteinander verbunden werden. Durchbruch 6 befindet sich im oberen der Leiterverbundsysteme.

Fig. 4d zeigt ein Mehrlagensystem aus zwei Leiterverbundsystemen, die jeweils aus einer Leiterstruktur 2 bzw. 2' und einem Träger 3 bzw. 3' bestehen. Auf dem unteren der beiden Leiterverbundsysteme ist ein IC- oder SMD-Baustein angeordnet. Das obere Leiterverbundsystem 2', 3' weist neben der Öffnung 6 eine Durchgangsöffnung 11 für den IC- oder SMD-Baustein auf.

In der Struktur gemäß Fig. 4e ist zwischen zwei Leiterverbundsystemen, die im wesentlichen denen der Fig. 4d entsprechen, eine Leadframe-Folie 4 mit aufgesetztem IC- oder SMD-Baustein 5 eingeschoben. In diesem Fall reicht der Durchbruch 6, 6' durch das obere Leiterverbundsystem 2', 3' und die Leadframe-Folie 4 hindurch.

Eine andere Möglichkeit zeigt Fig. 4f. Hier ist einerseits der IC- oder SMD-Baustein 5 auf dem unteren Leiterverbundsystem angeordnet und in der Leadframe-Folie 4 eine entsprechende Öffnung 11' vorgesehen. Die Durchbrüche 6, 6' befinden sich im oberen und unteren Leiterverbundsystem. Zur Herstellung der Verbindung wird von beiden Seiten der Struktur thermische Energie zugeführt (10").

Die Anordnung der Durchbrüche 6, 6' richtet sich nach der Lage der Verbindungsstellen im Mehrlagensystem. Anstatt durch thermische Energie kann die Verbindung zwischen den Leiterstrukturen jeweils auch mit Hilfe leitfähiger Massen hergestellt werden.

Die erfindungsgemäßen Leiterverbundsysteme und die erfindungsgemäß herstellbaren Mehrlagensysteme sind einfach und kostengünstig erhältlich. Die erfindungsgemäß hergestellten Verbindungen zwischen den einzelnen Schichten sind stabil. Dennoch erfordert ihre Herstellung nur geringen Energieeintrag. Da die Verbindungsenergie durch die Durchbrüche der Verbindungsstelle gezielt zugeführt werden kann, wird ein Aufschmelzen der Träger außerhalb der Verbindungsbereiche weitgehend vermieden. Es können thermoplastische Träger verwendet werden. Die erfindungsgemäße Ausgestaltung der Leiterverbundsysteme ermöglicht zudem die optische Kontrolle der hergestellten Verbindung. Außerdem können die Durchgangsöffnungen sowohl bei der Herstellung als auch im fertigen Mehrlagensystem als optische Positionierungs- und Zentrierungshilfen dienen.

## Patentansprüche

1. Verfahren zur Herstellung wenigstens einer elektrisch leitenden Verbindung zwischen zwei oder mehr Leiterstrukturen (2, 2', 4, 4'), von denen wenigstens eine mit einem Träger (3, 3') zu einem Leiterverbundsystem verbunden ist, wobei wenigstens einer der Träger (3, 3') aus thermoplastischem Kunststoff besteht und worin wenigstens eines der Leiterverbundsysteme im Bereich der Kontaktstellen der Leiterstruktur Durchbrüche (6, 6') aufweist,
**dadurch gekennzeichnet,**
daß zur Herstellung der elektrisch leitenden Verbindung der Verbindungsstelle durch die Durchbrüche (6, 6') direkt und gezielt thermische Energie zugeführt wird.

2. Verfahren gemäß Anspruch 1,
**dadurch gekennzeichnet,**
daß in die Durchbrüche (6, 6') eine elektrisch leitende Masse (9) eingebracht wird.

3. Verfahren gemäß Anspruch 2,
**dadurch gekennzeichnet,**
daß die elektrisch leitende Masse (9) eine Leitpaste, ein Leitkleber, eine Lotpaste oder eine Lotfolie ist.

4. Verfahren gemäß einem der Ansprüche 1 bis 3,
**dadurch gekennzeichnet,**
daß die thermische Energie durch Wärmestrahlung, durch Schweißverfahren, insbesondere Punkt-, Gap- oder Spaltschweißen, Löt-, Ultraschall-, Thermokompressions-, Thermosonic- oder Laserverfahren (10, 10', 10") zugeführt wird.

5. Verfahren gemäß einem der Ansprüche 1 bis 4,
**dadurch gekennzeichnet,**
daß die Leiterstrukturen (2, 2') auf je einem Träger (3, 3') angeordnet oder in diesen integriert sind.

6. Verfahren gemäß Anspruch 5,
**dadurch gekennzeichnet,**
daß sämtliche Träger (3, 3') aus einem thermoplastischen Kunststoff bestehen.

7. Verfahren gemäß Anspruch 6,
**dadurch gekennzeichnet,**
daß die Verbindung im Bereich von Durchbrüchen hergestellt wird, die sich im dickeren der Leiterverbundsysteme (2, 3 bzw. 2', 3') befinden.

8. Verfahren gemäß einem der Ansprüche 1 bis 7 zur Herstellung einer elektrisch leitenden Verbindung zwischen einem in eine Folie integrierten metallischen Anschlußrahmen (4) und mindestens einer auf einem thermoplastischen Träger (3, 3') angeordneten Leiterstruktur (2, 2').

## Claims

1. Method for making at least one electrically conductive connection between two or more conductor structures (2, 2', 4, 4'), at least one of which is connected to a carrier (3, 3') to form a composite conductor system, at least one of the carriers (3,3') consisting of thermoplastic and in which at least one of the composite conductor systems having perforations (6, 6') in the region of the contact points of the conductor structure, characterized in that thermal energy is supplied to the connection point directly and in a controlled manner through the perforations (6,6') in order to make the electrically conductive connection.

2. method according to Claim 1, characterized in that an electrically conductive mass (9) is introduced into the perforations (6,6').

3. Method according to Claim 2, characterized in that the electrically conductive mass (9) is a conductive paste, a conductive adhesive, a solder paste or a solder foil.

4. Method according to one of Claims 1 to 3, characterized in that the thermal energy is supplied by heat radiation, by means of welding methods, in particular spot, gap or close welding, soldering, ultrasonic, thermocompression, thermosonic or laser methods (10, 10', 10").

5. Method according to one of Claims 1 to 4, characterized in that the conductor structures (2, 2') are each arranged on a carrier (3, 3') or integrated into this.

6. Method according to Claim 5, characterized in that all of the carriers (3,3') consist of a thermoplastic.

7. Method according to Claim 6, characterized in that the connection is made in the region of perforations which are located in the thicker of the composite conductor systems (2, 3 or 2', 3').

8. Method according to one of Claims 1 to 7 for making an electrically conductive connection between a metallic leadframe (4) integrated into a foil and at least one conductor structure (2, 2') arranged on a thermoplastic carrier (3, 3').

## Revendications

1. Procédé pour réaliser au moins une connexion électroconductrice entre au moins deux structures de conducteurs (2, 2', 4, 4') dont au moins l'une d'elles est reliée par un support (3, 3') à un système compact de conducteurs, au moins l'un des supports (3, 3') étant en matière thermoplastique et au moins un des systèmes compacts de conducteurs comportant, dans la zone des points de connexion de la structure de conducteurs, des ouvertures (6, 6'),
**caractérisé par le fait**
que, pour la réalisation de la connexion électroconductrice, de l'énergie thermique est appliquée, à travers les ouvertures (6, 6'), directement et d'une façon spécifique, au point de connexion.

2. Procédé conforme à la revendication 1
**caractérisé par le fait**
qu'un produit électroconducteur (9) est introduit dans les ouvertures (6, 6').

3. Procédé conforme à la revendication 2
**caractérisé par le fait**
que le produit électroconducteur (9) est une pâte conductrice, une colle conductrice, une pâte à souder ou une membrane à souder.

4. Procédé conforme à l'une des revendications 1 à 3
**caractérisé par le fait**
que l'énergie thermique est appliquée par rayonnement calorifique, par un procédé de soudure, en particulier de soudure point par point, de soudure à vides ou par capillarité, par un procédé de brasage, à ultrasons, à thermocompression, thermosonique ou à laser (10, 10', 10").

5. Procédé conforme à l'une des revendications 1 à 4
**caractérisé par le fait**
que les structures de conducteurs (2, 2') sont montées chacune sur un support (3, 3') ou intégrées dans ce dernier.

6. Procédé conforme à la revendication 5
**caractérisé par le fait**
que tous les supports (3, 3') sont constitués de matière thermoplastique.

7. Procédé conforme à la revendication 6
**caractérisé par le fait**
que la connexion est réalisée dans la zone des ouvertures qui se trouvent dans le plus épais des systèmes compacts de conducteurs (2, 3 et respectivement 2', 3').

8. Procédé conforme à l'une des revendications 1 à 7 pour réaliser une connexion électroconductrice entre un cadre métallique de connexion (4) intégré dans une membrane et au moins une structure de conducteurs (2, 2') montée sur un support thermoplastique (3, 3').
